# EUROPEAN PATENT APPLICATION

(11) **EP 4 549 900 A1**
(43) Date of publication of application: **07.05.2025**
(21) Application number: 23872045.2
(22) Date of filing: 19.09.2023
(51) Int. Cl.: G01L 1/14, B62D 1/06

(54) **CONTACT DETECTION DEVICE**

(30) Priority: 30.09.2022 JP 2022158513
(71) Applicant: Sumitomo Riko Company Limited, Komaki-shi, Aichi 485-8550 (JP)
(72) Inventor: SUGIYAMA, Takami, Komaki-shi, Aichi 485-8550 (JP); YOSHIDA, Satoshi, Komaki-shi, Aichi 485-8550 (JP); TSUNAKI, Ichiro, Komaki-shi, Aichi 485-8550 (JP); MAEDA, Takuma, Komaki-shi, Aichi 485-8550 (JP)
(74) Representative: Becker, Eberhard
(86) International application number: PCT/JP2023/033934
(87) International publication number: WO 2024/070817

(57) **Abstract**

A contact detection device (10) in which an AC power supply (11) applies, while switching between, a first AC voltage and a second AC voltage having different frequencies, onto a first electrode layer (22) and a second electrode layer (23), the contact detection device (10) comprising: a storage unit (34) that stores an alternative quadrature component (QA) corresponding to a state in which a conductor is in contact with an electrostatic sensor (7); a quadrature component comparison unit (31) that makes a comparison between a first quadrature component (Q1) extracted when the first AC voltage is applied onto the second electrode layer (23) and a second quadrature component (Q2) extracted when a second AC voltage is applied onto the second electrode layer (23); and a contact determining unit (33) that detects contact by a conductor on the basis of the first quadrature component (Q1) if the first quadrature component (Q1) and the second quadrature component (Q2) are within the range of a first quadrature error (ΔQE1), and detects contact by a conductor on the basis of the alternative quadrature component (QA) if the first quadrature component (Q1) and the second quadrature component (Q2) are outside the range of the first quadrature error (ΔQE1).

## Description

### Technical Field

The present disclosure relates to a contact detection device.

### Related Art

In a known contact detection device, for example, by incorporating an electrostatic capacitive sensor within a steering wheel of an automobile, it is detected whether a person is touching a steering wheel. In the contact detection device, when measuring an electrostatic capacitance, an impedance measurement is used to calculate a capacitive component by applying a voltage waveform with a constant cycle to a sensor electrode and comparing the original applied waveform with a measured waveform passing through the sensor.

### Related Art Documents

### Patent Documents

Patent Document 1: Japanese Patent Application Laid-Open No. 2021-190990

### SUMMARY

### Problems to Be Solved

The impedance measurement according to the related art is based on the following: when a voltage is applied to a target object, a phase of the current is delayed due to the capacitive component of the sensor electrode, and a phase difference occurs between the measured voltage waveform and the applied voltage waveform. Thus, when noise of a frequency in the vicinity of a frequency of the applied voltage is inputted to the sensor or the like during impedance measurement, the applied waveform is distorted, and accurate electrostatic capacitance measurement cannot be performed.

The present disclosure has been made in view of such background and aims to provide a contact detection device with reduced influence of noise.

### Means for Solving Problem

An aspect of the present disclosure is a contact detection device including an electrostatic sensor, an AC power supply, a quadrature demodulator, and a measuring instrument. The electrostatic sensor includes a detection electrode and detects contact of a conductor. The AC power supply applies an AC voltage to the detection electrode. The quadrature demodulator extracts at least a quadrature component in a case where an impedance of the electrostatic sensor is represented by an in-phase component and the quadrature component, using a signal outputted from the detection electrode upon applying the AC voltage to the detection electrode. The measuring instrument detects whether the conductor is in contact with the electrostatic sensor based on the quadrature component extracted by the quadrature demodulator. The AC power supply switches between a first AC voltage of a first frequency and a second AC voltage of a second frequency different from the first frequency to apply the first AC voltage and the second AC voltage to the detection electrode. The measuring instrument includes a storage part, a quadrature component comparison part, and a contact determination part. The storage part stores an alternative quadrature component corresponding to a state in which the conductor is in contact with the electrostatic sensor. The quadrature component comparison part compares between a first quadrature component extracted by the quadrature demodulator upon applying the first AC voltage to the detection electrode, and a second quadrature component extracted by the quadrature demodulator upon applying the second AC voltage to the detection electrode. The contact determination part detects contact of the conductor with the electrostatic sensor based on the first quadrature component in a case where the first quadrature component and the second quadrature component fall within a range of a predetermined first quadrature error, and detects contact of the conductor with the electrostatic sensor based on the alternative quadrature component stored in the storage part in a case where the first quadrature component and the second quadrature component fall outside the range of the first quadrature error.

### Effect

According to an aspect of the present disclosure, even if noise of a frequency in the vicinity of the first frequency is mixed in, contact of a conductor with the detection electrode can be detected based on the second quadrature component of the second AC voltage. Further, in the case where noise of a frequency in the vicinity of the second frequency is mixed in, contact of the conductor with the detection electrode can be detected based on the alternative quadrature component stored in the storage part. Accordingly, influence of noise on the contact detection device can be reduced.

Reference signs in parentheses described in the claims indicate correspondence with specific means described in embodiments below and do not limit the technical scope of the present disclosure.

### BRIEF DESCRIPTION OF DRAWINGS

FIG. 1 is a front view showing a steering wheel to which a contact detection device according to Embodiment 1 is applied.
FIG. 2 is a cross-sectional view taken along line **II-II** in FIG. 1.
FIG. 3 is a cross-sectional view showing an electrostatic sensor of Embodiment 1.
FIG. 4 is a block diagram showing a configuration of the contact detection device of Embodiment 1.
FIG. 5 is a schematic view showing, by quadrature components and in-phase components, output impedances of the electrostatic sensor of Embodiment 1 in a state in which there is no influence of noise and a conductor is not in contact.
FIG. 6 is a schematic view showing, by quadrature components and in-phase components, an output impedance in a state in which a conductor is in contact and an output impedance in a state in which a conductor is not in contact, of the electrostatic sensor of Embodiment 1.
FIG. 7 is a flowchart showing a main flow of an action of the contact detection device of Embodiment 1.
FIG. 8 is a flowchart showing a noise determination process of Embodiment 1.
FIG. 9 is a flowchart showing a quadrature component comparison process of Embodiment 1.
FIG. 10 is a flowchart showing an in-phase component comparison process of Embodiment 1.
FIG. 11 is a block diagram showing a configuration of a contact detection device of Embodiment 2.
FIG. 12 is a flowchart showing a noise determination process of Embodiment 2.
FIG. 13 is a flowchart showing a quadrature component comparison process of Embodiment 2.
FIG. 14 is a flowchart showing an in-phase component comparison process of Embodiment 2.

### DESCRIPTION OF EMBODIMENTS

### (Embodiment 1)

### 1. Configuration of steering wheel 1

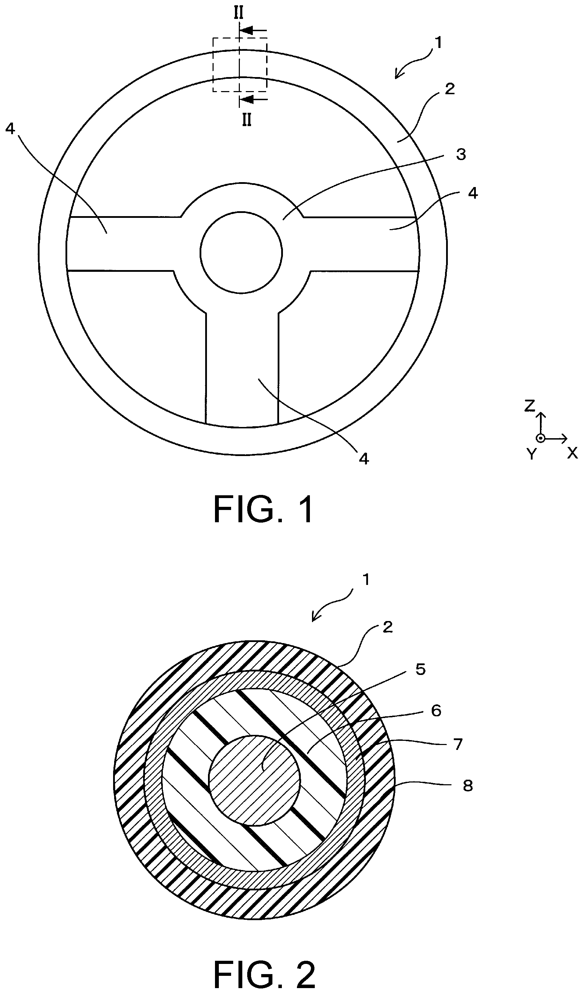

In Embodiment 1, a contact detection device 10 according to the present disclosure is applied to a steering wheel 1 of a vehicle (not shown). First, a structure of the steering wheel 1 will be described with reference to FIG. 1 and FIG. 2. As shown in FIG. 1, the steering wheel 1 includes a ring part 2 formed in a circular ring shape, a core part 3 formed smaller than the ring part 2 and disposed on a radially inner side of the ring part 2, and a plurality (three in this embodiment) of connecting parts 4 that connect the core part 3 and the ring part 2. However, the number of connecting parts 4 is not particularly limited and may also be one, two, or four or more.

In the following description, a right side as viewed from a driver (not shown) seated in a vehicle (not shown) is a direction indicated by an arrow X, an upper side as viewed from the driver is a direction indicated by an arrow Z, and a direction approaching a front of the driver is a direction indicated by an arrow Y.

As shown in FIG. 2, the ring part 2 includes a core body 5, a resin inner layer material 6, an electrostatic sensor 7, and a skin material 8. The core body 5 constitutes a central part of the ring part 2 and is formed in a shape corresponding to the shape of the ring part 2. In other words, the core body 5 is formed in a circular ring shape and has a circular cross section perpendicular to its axis. Herein, the cross-sectional shape of the core body 5 perpendicular to its axis is not limited to a circular shape, and may also be any shape such as an elliptical shape, an oval shape, a U-shape, a C-shape, or a polygonal shape. In this embodiment, the core body 5 is formed of metal such as aluminum or magnesium and has conductivity. The material of the core body 5 may also be a material other than metal.

The resin inner layer material 6 covers an entire circumference of the ring shape of the core body 5 on an outer surface of the core body 5, and covers an entire circumference of the circular cross-sectional shape of the core body 5. In this embodiment, a cross section of the resin inner layer material 6 perpendicular to its axis is formed in a circular shape. In the case where the core body 5 has a U-shaped cross section perpendicular to its axis, the resin inner layer material 6 fills not only a radially outer side of the cross section of the core body 5 perpendicular to its axis but also a U-shaped recess of the core body 5. The resin inner layer material 6 is molded by injection molding on an outer surface side of the core body 5 and is directly bonded to the outer surface of the core body 5. The cross-sectional shape of the resin inner layer material 6 perpendicular to its axis is not limited to a circular shape and may also be any shape such as an oval shape, an elliptical shape, or a polygonal shape. The resin inner layer material 6 includes, for example, a foamed urethane resin. The resin inner layer material 6 may also include a non-foamed resin.

The electrostatic sensor 7 is disposed on an outer surface of the resin inner layer material 6. The electrostatic sensor 7 is configured such that an electrostatic capacitance equivalent value of the electrostatic sensor 7 changes as a conductor (not shown), such as a finger or a hand, contacts or approaches the electrostatic sensor 7. The electrostatic sensor 7 according to this embodiment is a steering wheel sensor applied to the steering wheel 1 of a vehicle. The electrostatic sensor 7 will be described in detail later.

The skin material 8 covers an entire circumference of the electrostatic sensor 7 on an outer surface (a surface of the electrostatic sensor 7 opposite to the resin inner layer material 6) of the electrostatic sensor 7. In other words, as will be described later, in the case where a first electrode layer 22 is exposed on a first surface 24 side of an insulating sheet 21, the skin material 8 also functions as a covering material of the first electrode layer 22. The skin material 8 is molded by injection molding and is wrapped around the outer surface side of the electrostatic sensor 7 and bonded to the outer surface of the electrostatic sensor 7. The skin material 8 is molded, for example, from a urethane resin. An outer surface of the skin material 8 constitutes a design surface. Thus, the skin material 8 preferably includes a non-foamed urethane resin or a slightly foamed urethane resin.

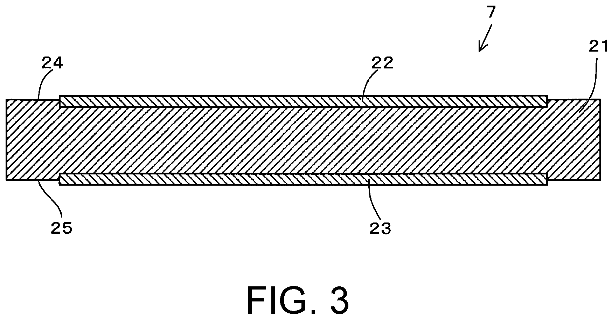

Next, with reference to FIG. 3, a configuration of the electrostatic sensor 7 will be described. The electrostatic sensor 7 includes a first electrode layer 22 and a second electrode layer 23. The first electrode layer 22 and the second electrode layer 23 have conductivity and are formed in layers. The first electrode layer 22 and the second electrode layer 23 are an example of a detection electrode.

The first electrode layer 22 is laminated on a first surface 24 of an insulating sheet 21. The first electrode layer 22 is formed in a similar shape slightly smaller than the insulating sheet 21. Accordingly, an edge of the first surface 24 of the insulating sheet 21 is exposed from an edge of the first electrode layer 22.

The second electrode layer 23 is laminated on a second surface 25 of the insulating sheet 21. The second electrode layer 23 is formed in a similar shape slightly smaller than the insulating sheet 21. Accordingly, an edge of the second surface 25 of the insulating sheet 21 is exposed from an edge of the second electrode layer 23.

The first electrode layer 22 and the second electrode layer 23 may be of the same shape and size, or one of them may be in a similar shape slightly larger than the other.

The insulating sheet 21 is formed to include, for example, an elastomer as a main component. Thus, the insulating sheet 21 is flexible. In other words, the insulating sheet 21 has flexibility and is configured to be extendable in a planar direction. The insulating sheet 21 is formed to include, for example, a thermoplastic material, particularly a thermoplastic elastomer, as a main component. The insulating sheet 21 may be formed of a thermoplastic elastomer itself, or may be formed of an elastomer as a main component cross-linked by heating a thermoplastic elastomer as a material.

Further, the insulating sheet 21 may also include a rubber, a resin, or another material other than the thermoplastic elastomer. For example, in the case where the insulating sheet 21 includes a rubber such as an ethylene-propylene rubber (EPM, EPDM), flexibility of the insulating sheet 21 is improved. From the perspective of improving flexibility of the insulating sheet 21, the insulating sheet 21 may also contain a flexibility-imparting component such as a plasticizer. Furthermore, the insulating sheet 21 may also be configured with a reaction-curable elastomer or a thermosetting elastomer as a main component.

Furthermore, the insulating sheet 21 preferably includes a material with good thermal conductivity. Thus, the insulating sheet 21 may include a thermoplastic elastomer with high thermal conductivity, or may contain a filler capable of enhancing thermal conductivity.

The first electrode layer 22 is disposed on the first surface 24 side of the insulating sheet 21, and the second electrode layer 23 is disposed on the second surface 25 side of the insulating sheet 21. The first electrode layer 22 and the second electrode layer 23 have conductivity. Furthermore, the first electrode layer 22 and the second electrode layer 23 are flexible. In other words, the first electrode layer 22 and the second electrode layer 23 have flexibility and are configured to be extendable in a planar direction.

The first electrode layer 22 and the second electrode layer 23 may be formed of a conductive elastomer. In the case where the first electrode layer 22 and the second electrode layer 23 are formed of a conductive elastomer, the first electrode layer 22 and the second electrode layer 23 are formed to include an elastomer as a base material and contain a conductive filler. The elastomer serving as the base material of the first electrode layer 22 and the second electrode layer 23 may have a same main component as the insulating sheet 21 or may include a different material. The first electrode layer 22 and the second electrode layer 23 are bonded with the insulating sheet 21 by mutual fusion (thermal fusion).

The first electrode layer 22 and the second electrode layer 23 may also be formed of a conductive cloth. The conductive cloth is a woven or non-woven fabric formed of a conductive fiber. Herein, the conductive fiber is formed by coating a surface of a flexible fiber with a conductive material. For example, the conductive fiber may be formed by plating copper, nickel, etc. onto the surface of a resin fiber such as polyethylene. In that case, the first electrode layer 22 and the second electrode layer 23 are bonded to the insulating sheet 21 by fusion (thermal fusion) of the insulating sheet 21 itself.

The first electrode layer 22 and the second electrode layer 23 may also be formed of a metal foil. The metal foil may be any conductive metal material, such as a copper foil or an aluminum foil. Furthermore, similar to the case of using a conductive cloth, the first electrode layer 22 and the second electrode layer 23 are bonded to a sensor sheet by fusion (thermal fusion) of the insulating sheet 21 itself.

### 3. Overall configuration of contact detection device 10

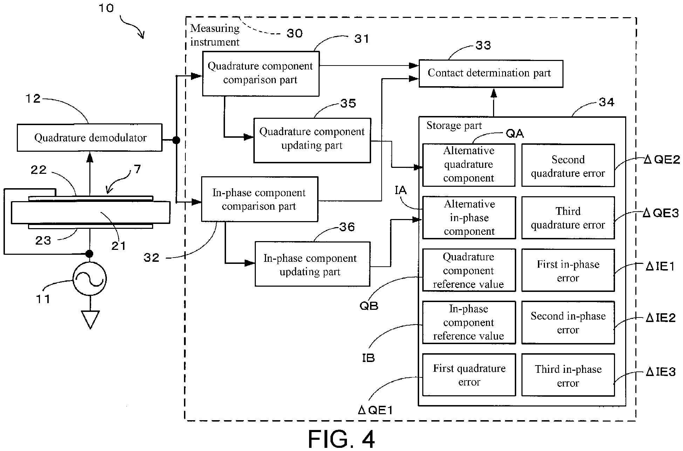

As shown in FIG. 4, the contact detection device 10 includes an electrostatic sensor 7, an AC power supply 11, a quadrature demodulator 12, and a measuring instrument 30. An AC voltage from the AC power supply 11 is applied to the first electrode layer 22 and the second electrode layer 23 of the electrostatic sensor 7.

### (1) AC power supply 11

The AC power supply 11 switches between a first AC voltage of a first frequency, a second AC voltage of a second frequency, and a third AC voltage of a third frequency at a predetermined cycle to apply the AC voltage to the first electrode layer 22 and the second electrode layer 23. The first frequency, the second frequency, and the third frequency are different from each other. However, the number of frequencies of the AC voltage applied to the first electrode layer 22 and the second electrode layer 23 is not limited to three and may also be two or four or more.

In this embodiment, the first frequency is greater than the second frequency, and the second frequency is greater than the third frequency. In this embodiment, the first frequency is 100 to 150 kHz, the second frequency is 50 to 100 kHz, and the third frequency is 5 to 50 kHz. However, the frequency bands of the first frequency, the second frequency, and the third frequency are not limited to the numerical ranges described above.

By setting the first frequency to 100 to 150 kHz, for example, influences of noise based on a switching frequency (100 kHz) of a DC-DC converter for a vehicle smart key, noise based on an amateur radio (135.7 kHz, 137.8 kHz), etc. can be reduced

By setting the second frequency to 50 to 100 kHz, for example, influences of noise based on wireless power transmission (79 to 90 kHz) and the like can be reduced.

By setting the third frequency to 5 to 50 kHz, for example, influences of noise based on standard radio waves (40 kHz, 60 kHz) received by a radio-controlled clock and the like can be reduced.

### (2) Quadrature demodulator 12

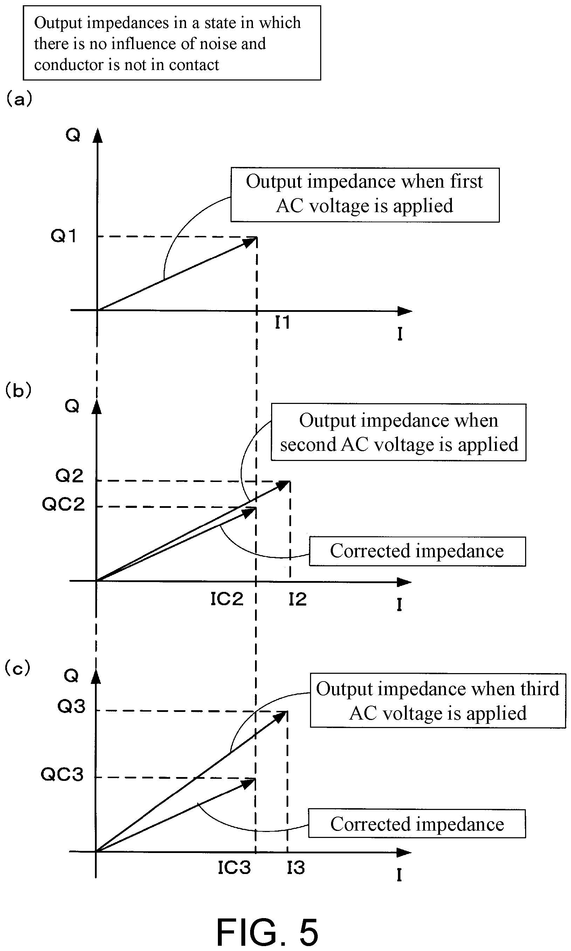

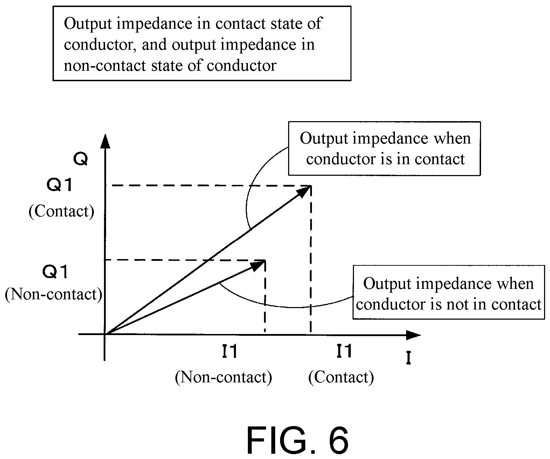

The quadrature demodulator 12 will be described with reference to FIG. 5 and FIG. 6. In the case where an impedance of the electrostatic sensor 7 is represented by an in-phase component and a quadrature component, the quadrature demodulator 12 extracts the quadrature component and the in-phase component using a signal outputted from the first electrode layer 22 upon applying an AC voltage to the second electrode layer 23. However, the quadrature demodulator 12 may also be configured to extract the quadrature component only.

With reference to (a) to (c) of FIG. 5, an action of the quadrature demodulator 12 will be described. (a) of FIG. 5 shows a graph representing, by a first quadrature component Q1 (an example of a first quadrature component) and a first in-phase component I1 (an example of a first in-phase component), an output impedance related to a signal outputted from the first electrode layer 22 when the first AC voltage is applied to the second electrode layer 23, in a state in which the electrostatic sensor 7 is not affected by noise and a conductor is not in contact with the first electrode layer 22. As described above, the quadrature demodulator 12 extracts the quadrature component and the in-phase component of the impedance of the electrostatic sensor 7 using the signal outputted from the first electrode layer 22.

(b) of FIG. 5 shows a graph representing, by a second quadrature component Q2 (an example of a second quadrature component) and a second in-phase component I2 (an example of a second in-phase component), an output impedance related to a signal outputted from the first electrode layer 22 when the second AC voltage is applied to the second electrode layer 23, in a state in which the electrostatic sensor 7 is not affected by noise and a conductor is not in contact with the first electrode layer 22.

Since the first frequency of the first AC voltage and the second frequency of the second AC voltage are different from each other, the first quadrature component Q1 and the second quadrature component Q2 are different from each other, and the first in-phase component I1 and the second in-phase component I2 are different from each other. Thus, by correcting the second quadrature component Q2 and the second in-phase component I2, the second quadrature component Q2 and the second in-phase component I2 are respectively converted into a corrected second quadrature component QC2 and a corrected second in-phase component IC2. Accordingly, it becomes possible to compare between the first quadrature component Q1 and the corrected second quadrature component QC2, and it becomes possible to compare between the first in-phase component I1 and the corrected second in-phase component IC2. In a state in which the electrostatic sensor 7 is not affected by noise, the first quadrature component Q1 and the corrected second quadrature component QC2 fall within the range of a first quadrature error ΔQE1 to be described later, and the first in-phase component I1 and the corrected second in-phase component IC2 fall within the range of a first in-phase error ΔIE1 to be described later.

(c) of FIG. 5 shows a graph representing, by a third quadrature component Q3 (an example of a third quadrature component) and a third in-phase component I3 (an example of a third in-phase component), an output impedance related to a signal outputted from the first electrode layer 22 when the third AC voltage is applied to the second electrode layer 23, in a state in which the electrostatic sensor 7 is not affected by noise and a conductor is not in contact with the first electrode layer 22.

Since the first frequency of the first AC voltage and the second frequency of the third AC voltage are different from each other, the first quadrature component Q1 and the third quadrature component Q3 are different from each other, and the first in-phase component I1 and the third in-phase component I3 are different from each other. Thus, by correcting the third quadrature component Q3 and the third in-phase component I3, the third quadrature component Q3 and the third in-phase component I3 are respectively converted into a corrected third quadrature component QC3 and a corrected third in-phase component IC3. Accordingly, it becomes possible to compare between the first quadrature component Q1 and the corrected third quadrature component QC3, and it becomes possible to compared between the first in-phase component I1 and the corrected third in-phase component IC3. In a state in which the electrostatic sensor 7 is not affected by noise, the first quadrature component Q1 and the corrected third quadrature component QC3 fall within a range of a second quadrature error ΔQE2 to be described later, and the first in-phase component I1 and the corrected third in-phase component IC3 fall within a range of a second in-phase error ΔIE2 to be described later.

Further, it is possible to compare between the corrected second quadrature component QC2 and the corrected third quadrature component QC3, and it is also possible to compare between the corrected second in-phase component IC2 and the corrected third in-phase component IC3. In a state in which the electrostatic sensor 7 is not affected by noise, the corrected second quadrature component QC2 and the corrected third quadrature component QC3 fall within a range of a third quadrature error ΔQE3 to be described later, and the corrected second in-phase component IC2 and the corrected third in-phase component IC3 fall within a range of a third in-phase error ΔIE3 to be described later.

The correction may be performed, for example, by multiplying the second quadrature component Q2, the second in-phase component I2, the third quadrature component Q3, and the third in-phase component I3 by correction coefficients, or by substituting the second quadrature component Q2, the second in-phase component I2, the third quadrature component Q3, and the third in-phase component I3 into correction functions. The correction coefficients or correction functions may be determined by experiments.

FIG. 6 shows an output impedance in a state in which a conductor is in contact with the first electrode layer 22 and an output impedance in a state in which a conductor is not in contact with the first electrode layer 22, in the case where the first AC voltage is applied to the electrostatic sensor 7. The state in which a conductor is in contact with the first electrode layer 22 includes both a state in which a conductor is in direct contact with the first electrode layer 22 and a state in which a conductor is in indirect contact with the first electrode layer 22 via the skin material 8.

Upon contact of a conductor with the first electrode layer 22, since both a capacitive component and a resistive component of the electrostatic sensor 7 increase, the output impedance at the time of contact of a conductor changes in a direction in which both the quadrature component and the in-phase component increase compared to an output impedance at the time of non-contact of a conductor. In other words, the first quadrature component Q1 (contact) at the time of contact of a conductor is greater than the first quadrature component Q1 (non-contact) at the time of non-contact of a conductor. Similarly, the first in-phase component I1 (contact) at the time of contact of a conductor is greater than the first in-phase component I1 (non-contact) at the time of non-contact of a conductor.

In the cases where the second AC voltage and the third AC voltage are applied to the electrostatic sensor 7, since similar tendencies are observed as in the case where the first AC voltage is applied as described above, repeated descriptions will be omitted.

### (3) Measuring instrument 30

Returning to FIG. 4, the measuring instrument 30 includes a quadrature component comparison part 31, an in-phase component comparison part 32, a contact determination part 33, a storage part 34, a quadrature component updating part 35, and an in-phase component updating part 36.

### (4) Storage part 34

As shown in FIG. 4, the storage part 34 stores an alternative quadrature component QA and an alternative in-phase component IA corresponding to the state in which a conductor is in contact with the electrostatic sensor 7. The alternative quadrature component QA is an initial value stored in advance in the storage part 34 and is a value that is not updated during contact detection performed by the measuring instrument 30. Similarly, the alternative in-phase component IA is an initial value stored in advance in the storage part 34 and is a value that is not updated during contact detection performed by the measuring instrument 30. However, when contact detection is not being performed by the measuring instrument 30, the alternative quadrature component QA and the alternative in-phase component IA are capable of being updated.

The storage part 34 further stores a quadrature component reference value QB and an in-phase component reference value IB. The quadrature component reference value QB is a quadrature component extracted from a signal outputted from the first electrode layer 22 when the first AC voltage is applied to the second electrode layer 23, in a state in which the electrostatic sensor 7 is not affected by noise and a conductor is not in contact with the first electrode layer 22. The in-phase component reference value IB is an in-phase component extracted from a signal outputted from the first electrode layer 22 when the first AC voltage is applied to the second electrode layer 23, in a state in which the electrostatic sensor 7 is not affected by noise and a conductor is not in contact with the first electrode layer 22.

The storage part 34 further stores a first quadrature error ΔQE1, a first in-phase error ΔIE1, a second quadrature error ΔQE2, a second in-phase error ΔIE2, a third quadrature error ΔQE3, and a third in-phase error ΔIE3.

The first quadrature error ΔQE1 is used to compare between the first quadrature component Q1 and the corrected second quadrature component QC2. The first in-phase error ΔIE1 is used to compare between the first in-phase component I1 and the corrected second in-phase component IC2.

The second quadrature error ΔQE2 is used to compare between the first quadrature component Q1 and the corrected third quadrature component QC3. The second in-phase error ΔIE2 is used to compare between the first in-phase component I1 and the corrected third in-phase component IC3.

The third quadrature error ΔQE3 is used to compare between the corrected second quadrature component QC2 and the corrected third quadrature component QC3. The third in-phase error ΔIE3 is used to compare between the corrected second in-phase component IC2 and the corrected third in-phase component IC3.

### (5) Quadrature component comparison part 31

The quadrature component comparison part 31 compares between quadrature components extracted by the quadrature demodulator 12 from signals of different frequencies outputted from the second electrode layer 23 when AC voltages of different frequencies are applied to the second electrode layer 23.

As shown in FIG. 4 and FIG. 5, in this embodiment, the quadrature component comparison part 31 compares between the first quadrature component Q1 and the second quadrature component Q2. The first quadrature component Q1 is extracted by the quadrature demodulator 12 from a signal outputted from the first electrode layer 22 when the first AC voltage is applied to the second electrode layer 23. The second quadrature component Q2 is extracted by the quadrature demodulator 12 from a signal outputted from the first electrode layer 22 when the second AC voltage is applied to the second electrode layer 23. However, the first quadrature component Q1 may also be compared with the corrected second quadrature component QC2 instead of the second quadrature component Q2.

Further, the quadrature component comparison part 31 compares between the first quadrature component Q1 and the third quadrature component Q3. The third quadrature component Q3 is extracted by the quadrature demodulator 12 from a signal outputted from the first electrode layer 22 when the third AC voltage is applied to the second electrode layer 23. However, the quadrature component comparison part 31 may also compare the first quadrature component Q1 with the corrected third quadrature component QC3 instead of the third quadrature component Q3.

Further, the quadrature component comparison part 31 compares between the second quadrature component Q2 and the third quadrature component Q3. However, the second quadrature component Q2 may be replaced with the corrected second quadrature component QC2, and the third quadrature component Q3 may be replaced with the corrected third quadrature component QC3. Thus, the quadrature component comparison part 31 may also compare between the corrected second quadrature component QC2 and the third quadrature component Q3, may also compare between the second quadrature component Q2 and the corrected third quadrature component QC3, and may also compare between the corrected second quadrature component QC2 and the corrected third quadrature component QC3.

### (6) In-phase component comparison part 32

The in-phase component comparison part 32 compares between in-phase components extracted by the quadrature demodulator 12 from signals of different frequencies outputted from the second electrode layer 23 when AC voltages of different frequencies are applied to the second electrode layer 23.

As shown in FIG. 4 and FIG. 5, in this embodiment, the in-phase component comparison part 32 compares between the first in-phase component I1 and the second in-phase component I2. The first in-phase component I1 is extracted by the quadrature demodulator 12 from a signal outputted from the first electrode layer 22 when the first AC voltage is applied to the second electrode layer 23. The second in-phase component I2 is extracted by the quadrature demodulator 12 from a signal outputted from the first electrode layer 22 when the second AC voltage is applied to the second electrode layer 23. However, the in-phase component comparison part 32 may also compare the first in-phase component I1 with the corrected second in-phase component IC2 instead of the second in-phase component I2.

Further, the in-phase component comparison part 32 compares between the first in-phase component I1 and the third in-phase component I3. The third in-phase component I3 is extracted by the quadrature demodulator 12 from a signal outputted from the first electrode layer 22 when the third AC voltage is applied to the second electrode layer 23. However, the in-phase component comparison part 32 may also compare the first in-phase component I1 with the corrected third in-phase component IC3 instead of the third in-phase component I3.

Further, the in-phase component comparison part 32 compares between the second in-phase component I2 and the third in-phase component I3. However, the second in-phase component I2 may be replaced with the corrected second in-phase component IC2, and the third in-phase component I3 may be replaced with the corrected third in-phase component IC3. Thus, the in-phase component comparison part 32 may also compare between the corrected second in-phase component IC2 and the third in-phase component I3, may also compare between the second in-phase component I2 and the corrected third in-phase component IC3, and may also compare between the corrected second in-phase component IC2 and the corrected third in-phase component IC3.

### (7) Contact determination part 33

As shown in FIG. 4, based on the result of comparison performed by the quadrature component comparison part 31, the contact determination part 33 selects a quadrature component that serves as a reference for detecting contact of a conductor with the electrostatic sensor 7. Further, based on the result of comparison performed by the in-phase component comparison part 32, the contact determination part 33 selects an in-phase component that serves as a reference for detecting contact of a conductor with the electrostatic sensor 7. The contact determination part 33 detects contact of a conductor with the electrostatic sensor 7 based on the selected quadrature component and the selected in-phase component.

Table 1 summarizes combinations of the selected quadrature component and the selected in-phase component.

**[Table 1]**

| | | Selected in-phase component | | |
|---|---|---|---|---|
| | | I1 | IC2 | IA |
| Selected quadrature component | Q1 | Q1, I1 | Q1, IC2 | Q1, IA |
| | QC2 | QC2, I1 | QC2, IC2 | QC2, IA |
| | QA | QA, I1 | QA, IC2 | QA, IA |

### (8) Quadrature component updating part 35

As shown in FIG. 4, in the case where the first quadrature component Q1 and the corrected second quadrature component QC2 fall within the range of the first quadrature error ΔQE1, the quadrature component updating part 35 updates the first quadrature component Q1 used by the contact determination part 33 as the alternative quadrature component QA stored in the storage part 34. Further, in the case where the first quadrature component Q1 and the corrected third quadrature component QC3 fall within the range of the second quadrature error ΔQE2, the quadrature component updating part 35 updates the first quadrature component Q1 used by the contact determination part 33 as the alternative quadrature component QA stored in the storage part 34. Further, in the case where the corrected second quadrature component QC2 and the corrected third quadrature component QC3 fall within the range of the third quadrature error ΔQE3, the quadrature component updating part 35 updates the corrected second quadrature component QC2 used by the contact determination part 33 as the alternative quadrature component QA stored in the storage part 34.

### (9) In-phase component updating part 36

As shown in FIG. 4, in the case where the first in-phase component I1 and the corrected second in-phase component IC2 fall within the range of the first in-phase error ΔIE1, the in-phase component updating part 36 updates the first in-phase component I1 used by the contact determination part 33 as the alternative in-phase component IA stored in the storage part 34. Further, in the case where the first in-phase component I1 and the corrected third in-phase component IC3 fall within the range of the second in-phase error ΔIE2, the in-phase component updating part 36 updates the first in-phase component I1 used by the contact determination part 33 as the alternative in-phase component IA stored in the storage part 34. Further, in the case where the corrected second in-phase component IC2 and the corrected third in-phase component IC3 fall within the range of the third in-phase error ΔIE3, the in-phase component updating part 36 updates the corrected second in-phase component IC2 used by the contact determination part 33 as the alternative in-phase component IA stored in the storage part 34.

### 4. Action of contact detection device 10

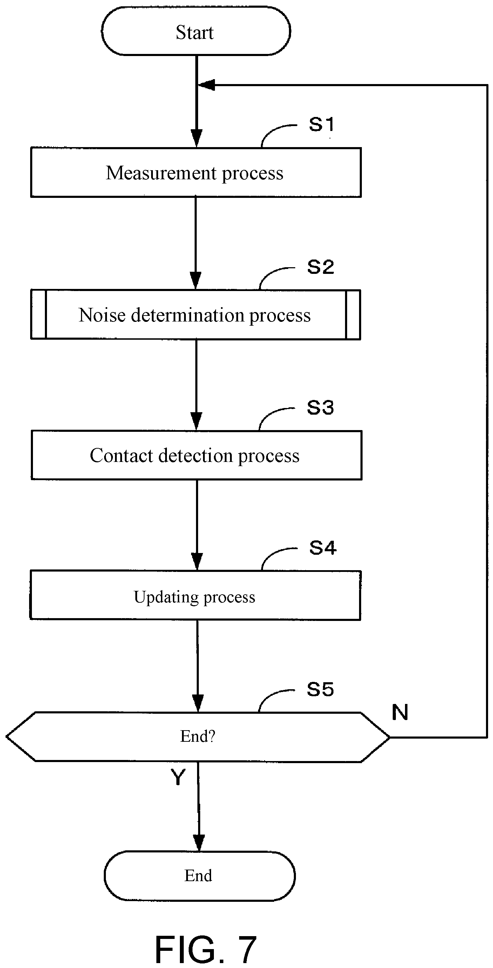

FIG. 7 shows a main routine related to an action of the contact detection device 10. Upon activation of the contact detection device 10, a measurement process (S1) is executed.

### (1) Measurement process (S1)

In the measurement process (S1), a first quadrature component Q1 and a first in-phase component I1 are measured (see (a) of FIG. 5). Further, in the measurement process (S1), a second quadrature component Q2 and a second in-phase component I2 are measured, and are respectively corrected to a corrected second quadrature component QC2 and a corrected second in-phase component IC2 (see (b) of FIG. 5). Further, in the measurement process (S1), a third quadrature component Q3 and a third in-phase component I3 are measured, and are respectively corrected to a corrected third quadrature component QC3 and a corrected third in-phase component IC3 (see (c) of FIG. 5).

### (2) Noise determination process

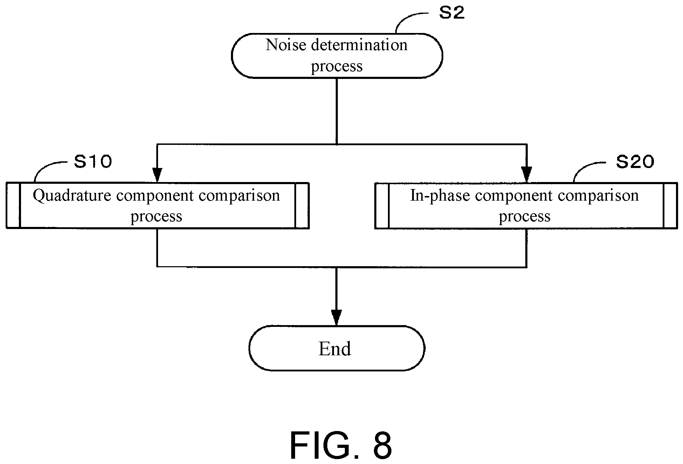

As shown in FIG. 7, upon execution of the measurement process (S1), a noise determination process (S2) is executed. In the noise determination process (S2), it is determined whether the electrostatic sensor 7 is affected by noise. FIG. 8 shows a flowchart of the noise determination process. Upon execution of the noise determination process (S2), a quadrature component comparison process (S10) and an in-phase component comparison process (S20) are executed at the same time, and the noise determination process (S2) ends.

### (A) Quadrature component comparison process

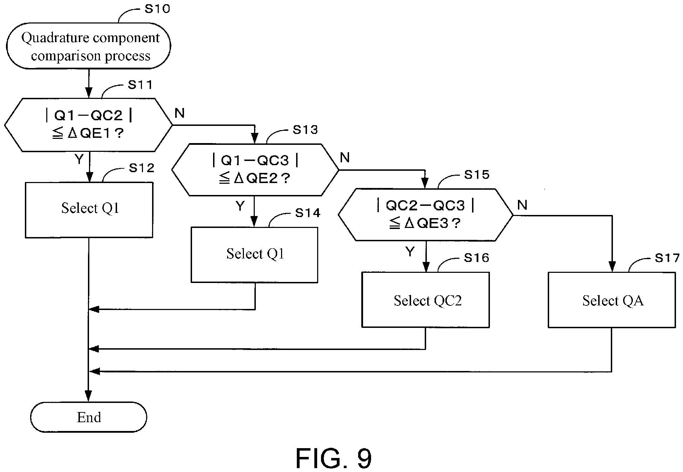

FIG. 9 shows a flowchart of the quadrature component comparison process (S10). Upon execution of the quadrature component comparison process (S10), the quadrature component comparison part 31 compares between the first quadrature component Q1 and the corrected second quadrature component QC2 (see FIG. 5). When the first quadrature component Q1 and the corrected second quadrature component QC2 fall within the range of a first quadrature error ΔQE1 stored in the storage part 34 (S11: Y), the quadrature component comparison part 31 selects the first quadrature component Q1 as a reference value for detecting contact of a conductor with the electrostatic sensor 7 (S12). Due to the nature of impedance, the greater the frequency, the higher accuracy of contact detection of the conductor. Thus, by adopting the first quadrature component Q1 obtained by applying the first AC voltage of the first frequency greater than the second frequency, the accuracy of detecting whether a conductor is in contact with the electrostatic sensor 7 can be improved. Accordingly, the quadrature component comparison process (S10) ends.

When the first quadrature component Q1 and the corrected second quadrature component QC2 do not fall within the range of the first quadrature error ΔQE1 (S11: N), it is determined that the electrostatic sensor 7 is affected by noise having a frequency in the vicinity of the first frequency or noise having a frequency in the vicinity of the second frequency.

Next, the quadrature component comparison part 31 compares between the first quadrature component Q1 and the corrected third quadrature component QC3 (see FIG. 5). When the first quadrature component Q1 and the corrected third quadrature component QC3 fall within the range of a second quadrature error ΔQE2 stored in the storage part 34 (S13: Y), the quadrature component comparison part 31 selects the first quadrature component Q1, which is based on the first frequency greater than the third frequency, as a reference value for detecting contact of a conductor with the electrostatic sensor 7 (S14). Accordingly, the quadrature component comparison process (S10) ends.

When the first quadrature component Q1 and the corrected third quadrature component QC3 do not fall within the range of the second quadrature error ΔQE2 (S13: N), it is determined that the electrostatic sensor 7 is affected by noise having a frequency in the vicinity of the first frequency or noise having a frequency in the vicinity of the third frequency.

Next, the quadrature component comparison part 31 compares between the corrected second quadrature component QC2 and the corrected third quadrature component QC3 (see FIG. 5). When the corrected second quadrature component QC2 and the corrected third quadrature component QC3 fall within the range of a third quadrature error ΔQE3 stored in the storage part 34 (S15: Y), the quadrature component comparison part 31 selects the corrected second quadrature component QC2, which is based on the second frequency greater than the third frequency, as a reference value for detecting contact of a conductor with the electrostatic sensor 7 (S16). Accordingly, the quadrature component comparison process (S10) ends.

When the corrected second quadrature component QC2 and the corrected third quadrature component QC3 do not fall within the range of the third quadrature error ΔQE3 (S15: N), it is determined that the electrostatic sensor 7 is affected by noise having a frequency in the vicinity of the second frequency or noise having a frequency in the vicinity of the third frequency.

Next, the quadrature component comparison part 31 selects an alternative quadrature component QA stored in the storage part 34 as a reference value for detecting contact of a conductor with the electrostatic sensor 7 (S17). Accordingly, the quadrature component comparison process (S10) ends.

### (B) In-phase component comparison process

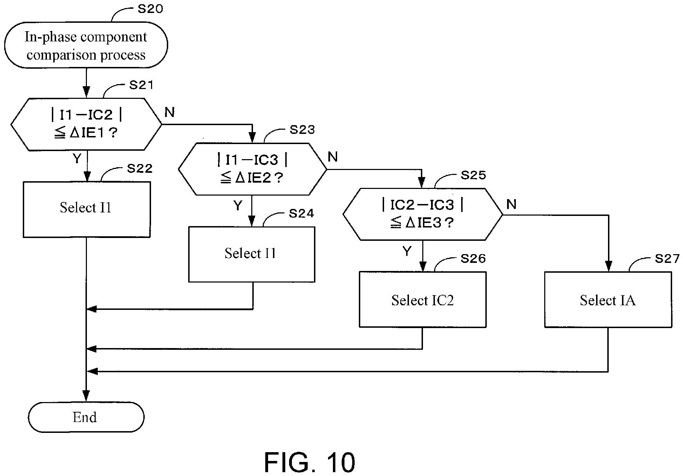

FIG. 10 shows a flowchart of the in-phase component comparison process (S20). The in-phase component comparison process is the same as "(A) Quadrature component comparison process" described above and FIG. 9, except that "quadrature" is replaced with "in-phase" and the reference sign "Q" is replaced with the reference sign "I". Thus, repeated descriptions will be omitted, and only conclusions will be described below.

In the case where the first in-phase component I1 and the corrected second in-phase component IC2 fall within the range of a first in-phase error ΔIE1 (S21: Y), the first in-phase component I1 is selected (S22).

In the case where the first in-phase component I1 and the corrected third in-phase component IC3 fall within the range of a second in-phase error ΔIE2 (S23: Y), the first in-phase component I1 is selected (S24).

In the case where the corrected second in-phase component IC2 and the corrected third in-phase component IC3 fall within the range of a third in-phase error ΔIE3 (S25: Y), the corrected second in-phase component IC2 is selected (S26).

In the case where the first in-phase component I1 and the corrected second in-phase component IC2 do not fall within the range of the first in-phase error ΔIE1 (S21: N), the first in-phase component I1 and the corrected third in-phase component IC3 do not fall within the range of the second in-phase error ΔIE2 (S23: N), and the corrected second in-phase component IC2 and the corrected third in-phase component IC3 do not fall within the range of the third in-phase error ΔIE3 (S25: N), an alternative in-phase component IA is selected (S27).

### (3) Contact detection process

As shown in FIG. 7, upon ending of the noise determination process (S2), a contact detection process (S3) is executed. In the contact detection process (S3), the contact determination part 33 detects contact of a conductor with the electrostatic sensor 7 based on the quadrature component Q1, Q2, and Q3 or the corrected quadrature component QC2 and QC3, and the in-phase component I1, I2, and I3 or the corrected in-phase component IC2 and IC3 selected in the noise determination process. In this embodiment, the contact determination part 33 detects contact of a conductor with the electrostatic sensor 7 based on the combinations shown in Table 1. However, combinations different from those shown in Table 1 may also be used. An action of the contact determination part 33 will be described below.

The contact determination part 33 calculates a difference between the quadrature component Q1, Q2, and Q3 or the corrected quadrature component QC2 and QC3 selected in the noise determination process (S2) and a quadrature component reference value QB stored in the storage part 34.

The contact determination part 33 determines that a conductor is in contact with the first electrode layer 22 when the difference between the quadrature component Q1, Q2 and Q3 or the corrected quadrature component QC2 and QC3 selected and the quadrature component reference value QB is greater than a predetermined threshold. Conversely, the contact determination part 33 determines that a conductor is not in contact with the first electrode layer 22 when the difference between the quadrature component Q1, Q2, and Q3 or the corrected quadrature component QC2 and QC3 selected and the quadrature component reference value QB is less than the predetermined threshold. The threshold may be stored in the storage part 34.

The contact determination part 33 calculates a difference between the in-phase component I1, I2, and I3 or the corrected in-phase component IC2 and IC3 selected in the noise determination process (S2) and an in-phase component reference value IB stored in the storage part 34.

The contact determination part 33 determines whether a conductor is in contact with the first electrode layer 22 of the electrostatic sensor 7 based on the difference between the in-phase component I1, I2, and I3 or the corrected in-phase component IC2 and IC3 selected and the in-phase component reference value IB, in the same manner as described above. Since the action is the same as described above except that "quadrature" is replaced with "in-phase" and the reference sign "Q" is replaced with the reference sign "I", repeated descriptions will be omitted. Accordingly, the contact detection process (S3) ends.

However, in this embodiment, it may be determined that a conductor is in contact with the first electrode layer 22 in the case of determining that a conductor is in contact with the first electrode layer 22 based on the quadrature component selected in the noise determination process (S2) and determining that a conductor is in contact with the first electrode layer 22 based on the in-phase component selected in the noise determination process (S2). Accordingly, the accuracy of contact detection of a conductor with the electrostatic sensor 7 can be improved.

Further, it is also possible to determine that a conductor is in contact with the first electrode layer 22 based solely on the quadrature component selected in the noise determination process (S2). Accordingly, the processing procedure of the contact detection process (S3) can be simplified.

Further, based on both the quadrature component selected in the noise determination process (S2) and the in-phase component selected in the noise determination process (S2), it is possible to precisely determine whether the conductor in contact with the first electrode layer 22 is a human body. For example, when the signal outputted from the first electrode layer 22 is represented by a quadrature component and an in-phase component, in the case where a vector representing the signal is located in a specific region, it may be determined that a human body such as a hand or a finger is in contact with the first electrode layer 22. In the case where the vector is located in another region, it may be determined that metal is in contact with the first electrode layer 22. Accordingly, contact of a conductor with the first electrode layer 22 can be precisely detected.

### (4) Updating process

As shown in FIG. 7, upon ending of the contact detection process (S3), an updating process (S4) is executed.

In the quadrature component comparison process (S10 in FIG. 9), in the case where the first quadrature component Q1 and the corrected second quadrature component QC2 fall within the range of the first quadrature error ΔQE1 (S11 in FIG. 9: Y), the quadrature component updating part 35 updates the first quadrature component Q1 used by the contact determination part 33 as the alternative quadrature component QA stored in the storage part 34.

Further, in the quadrature component comparison process (S10 in FIG. 9), in the case where the first quadrature component Q1 and the corrected third quadrature component QC3 fall within the range of the second quadrature error ΔQE2 (S13 in FIG. 9: Y), the quadrature component updating part 35 updates the first quadrature component Q1 used by the contact determination part 33 as the alternative quadrature component QA stored in the storage part 34.

Further, in the quadrature component comparison process (S10 in FIG. 9), in the case where the corrected second quadrature component QC2 and the corrected third quadrature component QC3 fall within the range of the third quadrature error ΔQE3 (S15 in FIG. 9: Y), the quadrature component updating part 35 updates the corrected second quadrature component QC2 used by the contact determination part 33 as the alternative quadrature component QA stored in the storage part 34.

Further, in the in-phase component comparison process (S20 in FIG. 10), in the case where the first in-phase component I1 and the corrected second in-phase component IC2 fall within the range of the first in-phase error ΔIE1 (S21 in FIG. 10: Y), the in-phase component updating part 36 updates the first in-phase component I1 used by the contact determination part 33 as the alternative in-phase component IA stored in the storage part 34.

Further, in the in-phase component comparison process (S20 in FIG. 10), in the case where the first in-phase component I1 and the corrected third in-phase component IC3 fall within the range of the second in-phase error ΔIE2 (S23 in FIG. 10: Y), the in-phase component updating part 36 updates the first in-phase component I1 used by the contact determination part 33 as the alternative in-phase component IA stored in the storage part 34.

Further, in the in-phase component comparison process (S20 in FIG. 10), in the case where the corrected second in-phase component IC2 and the corrected third in-phase component IC3 fall within the range of the third in-phase error ΔIE3 (S25 in FIG. 10: Y), the in-phase component updating part 36 updates the corrected second in-phase component IC2 used by the contact determination part 33 as the alternative in-phase component IA stored in the storage part 34. Thus, the updating process (S4) ends.

### (5) Ending selection

Next, as shown in FIG. 7, in the case where there is no ending instruction (S5: N), the processes from S1 to S4 are repeated. On the other hand, in the case where there is an ending instruction (S5: Y), the contact detection device 10 ends its action.

### 5. Effects of this embodiment

Next, effects of this embodiment will be described. According to this embodiment, even if noise of a frequency in the vicinity of the first frequency is mixed in, contact of a conductor with the first electrode layer 22 can be detected based on the corrected second quadrature component QC2 related to the second AC voltage. Further, even if noise of a frequency in the vicinity of the second frequency is mixed in, contact of a conductor with the first electrode layer 22 can be detected based on the first quadrature component Q1 related to the first AC voltage. Further, even if noise of frequencies in the vicinity of the first frequency and the second frequency is mixed in, or noise close to frequencies in the vicinity of the first frequency, the second frequency, and the third frequency is mixed in, contact of a conductor with the first electrode layer 22 can be detected based on the alternative quadrature component QA stored in the storage part 34. Accordingly, the influence of noise on the contact detection device 10 can be reduced.

Further, according to this embodiment, to detect contact of a conductor with the first electrode layer 22 of the electrostatic sensor 7, by using the in-phase component in addition to the quadrature component described above, accuracy of the contact detection device 10 can be improved.

According to this embodiment, in the case where noise of frequencies in the vicinity of the first frequency and the second frequency is mixed in, or noise close to frequencies in the vicinity of the first frequency, the second frequency, and the third frequency is mixed in, contact of a conductor with the first electrode layer 22 of the electrostatic sensor 7 can be detected based on the alternative quadrature component QA stored in the storage part 34 and used in a previous determination, and the alternative in-phase component IA stored in the storage part 34 and used in the previous determination.

Further, according to this embodiment, the first frequency is greater than the second frequency, and the second frequency is greater than the third frequency. Due to the nature of impedance, by applying an AC voltage with a great frequency, accuracy of the contact detection device 10 can be improved. According to this embodiment, in the case where noise of a frequency close to the first frequency is not mixed in, it is possible to detect contact of a conductor with the first electrode layer 22 based on the first AC voltage of the first frequency. Further, in the case where noise of a frequency close to the second frequency is not mixed in, it is possible to detect contact of a conductor with the first electrode layer 22 based on the second AC voltage of the second frequency. Thus, accuracy of the contact detection device 10 can be improved as much as possible.

Further, by using the alternative quadrature component QA stored in the storage part 34 and used in the previous determination, and the alternative in-phase component IA stored in the storage part 34 and used in the previous determination, over-time changes in the electrostatic sensor 7 can be addressed, so accuracy of the contact detection device 10 can be improved.

### (Embodiment 2)

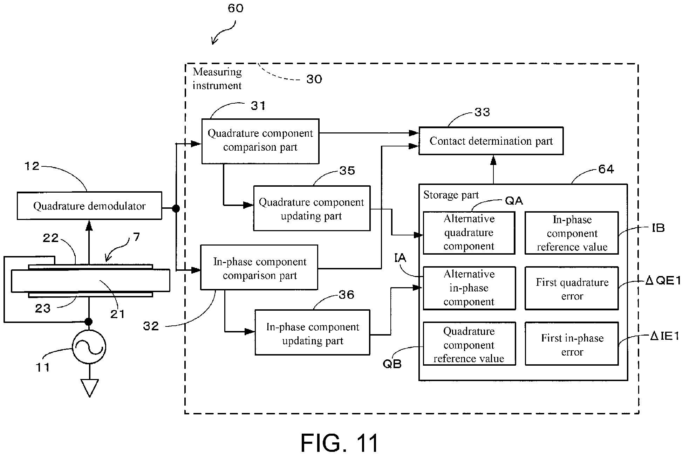

Next, with reference to FIG. 11, a configuration of a contact detection device 60 according to Embodiment 2 will be described. The AC power supply 11 of this embodiment switches between a first AC voltage of a first frequency and a second AC voltage of a second frequency at a predetermined cycle to apply the AC voltage to the first electrode layer 22 and the second electrode layer 23. The first frequency and the second frequency are different from each other. In this embodiment, the first frequency is greater than the second frequency.

The quadrature demodulator 12 of this embodiment extracts a first quadrature component Q1 and a first in-phase component I1 from a signal outputted from the first electrode layer 22 in the case where the first AC voltage is applied to the second electrode layer 23.

Further, from a signal outputted from the first electrode layer 22 in the case where the second AC voltage is applied to the second electrode layer 23, the quadrature demodulator 12 of this embodiment extracts a second quadrature component Q2 to generate a corrected second quadrature component QC2 and extracts a second in-phase component I2 to generate a corrected second in-phase component IC2.

As shown in FIG. 11, a storage part 64 of this embodiment stores an alternative quadrature component QA, an alternative in-phase component IA, a first quadrature error ΔQE1, and a first in-phase error ΔIE1.

The quadrature component comparison part 31 of this embodiment compares between the first quadrature component Q1 extracted by the quadrature demodulator 12 and the corrected second quadrature component QC2 generated by the quadrature demodulator 12. However, the quadrature component comparison part 31 may also compare the first quadrature component Q1 with the second quadrature component Q2 instead of the corrected second quadrature component QC2.

The in-phase component comparison part 32 of this embodiment compares between the first in-phase component I1 extracted by the quadrature demodulator 12 and the corrected second in-phase component IC2 generated by the quadrature demodulator 12. However, the in-phase component comparison part 32 may also compare the first in-phase component I1 with the second in-phase component I2 instead of the corrected second in-phase component IC2.

Based on the result of comparison performed by the quadrature component comparison part 31, the contact determination part 33 of this embodiment selects a quadrature component that serves as a reference for detecting contact of a conductor with the electrostatic sensor 7. Further, based on the result of comparison performed by the in-phase component comparison part 32, the contact determination part 33 selects an in-phase component that serves as a reference for detecting contact of a conductor with the electrostatic sensor 7. The contact determination part 33 detects contact of a conductor with the electrostatic sensor 7 based on the selected quadrature component and the selected in-phase component.

Table 2 summarizes combinations of the selected quadrature component and the selected in-phase component.

**[Table 2]**

| | | Selected in-phase component | |
|---|---|---|---|
| | | I1 | IA |
| Selected quadrature component | Q1 | Q1, I1 | Q1, IA |
| | QA | QA, I1 | QA, IA |

In the case where the first quadrature component Q1 and the corrected second quadrature component QC2 fall within the range of the first quadrature error ΔQE1, the quadrature component updating part 35 of this embodiment updates the first quadrature component Q1 used by the contact determination part 33 as the alternative quadrature component QA stored in the storage part 64.

In the case where the first in-phase component I1 and the corrected second in-phase component IC2 fall within the range of the first in-phase error ΔIE1, the in-phase component updating part 36 of this embodiment updates the first in-phase component I1 used by the contact determination part 33 as the alternative in-phase component IA stored in the storage part 64.

Configurations other than those described above are substantially the same as those in Embodiment 1, so repeated descriptions will be omitted.

Next, an action of the contact detection device 60 of this embodiment will be described. Differences between the action of the contact detection device 60 of this embodiment and the action of the contact detection device 60 of Embodiment 1 will be described, and repeated descriptions of the same action will be omitted.

Upon activation of the contact detection device 60 of this embodiment, a measurement process (S1 in FIG. 7) is executed. In the measurement process (S1) of this embodiment, a first quadrature component Q1 and a first in-phase component I1 are measured. Further, in the measurement process (S1) of this embodiment, a second quadrature component Q2 and a second in-phase component I2 are measured, and are respectively corrected to a corrected second quadrature component QC2 and a corrected second in-phase component IC2.

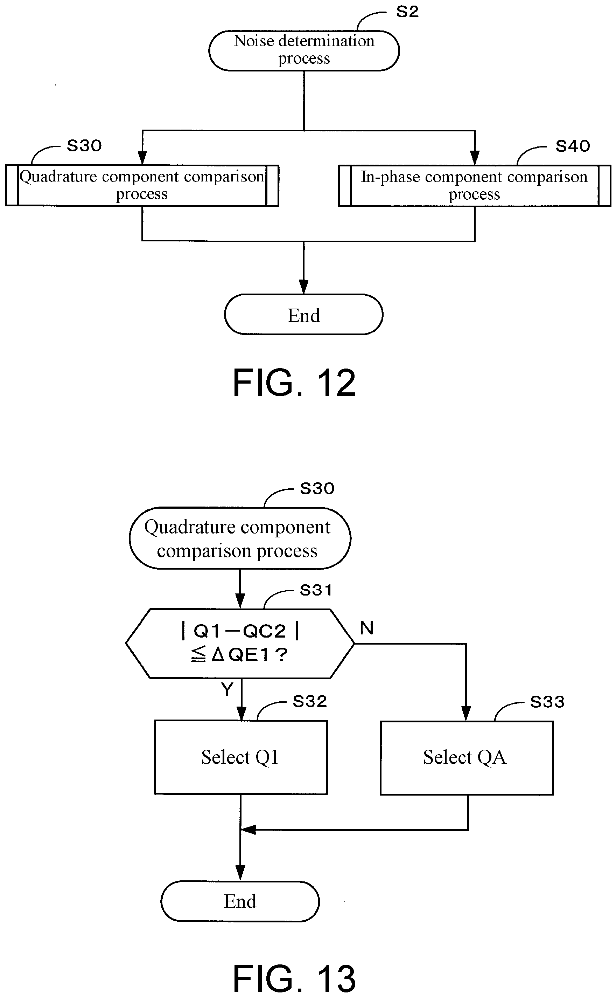

Next, a noise determination process (S2 in FIG. 7) is executed. As shown in FIG. 12, in this embodiment, upon execution of the noise determination process (S2), a quadrature component comparison process (S30 in FIG. 12) and an in-phase component comparison process (S40 in FIG. 12) are executed at the same time, and the noise determination process (S2) ends.

FIG. 13 shows a flowchart of the quadrature component comparison process (S30) of this embodiment. Upon execution of the quadrature component comparison process (S30), the quadrature component comparison part 31 compares between the first quadrature component Q1 and the corrected second quadrature component QC2. When the first quadrature component Q1 and the corrected second quadrature component QC2 fall within the range of a first quadrature error ΔQE1 stored in the storage part 64 (S31: Y), the quadrature component comparison part 31 selects the first quadrature component Q1 as a reference value for detecting contact of a conductor with the electrostatic sensor 7 (S32).

In the case where the first quadrature component Q1 and the corrected second quadrature component QC2 do not fall within the range of the first quadrature error ΔQE1 (S31: N), the quadrature component comparison part 31 selects the alternative quadrature component QA stored in the storage part 64 as a reference value for detecting contact of a conductor with the electrostatic sensor 7 (S33). Accordingly, the quadrature component comparison process (S30) ends.

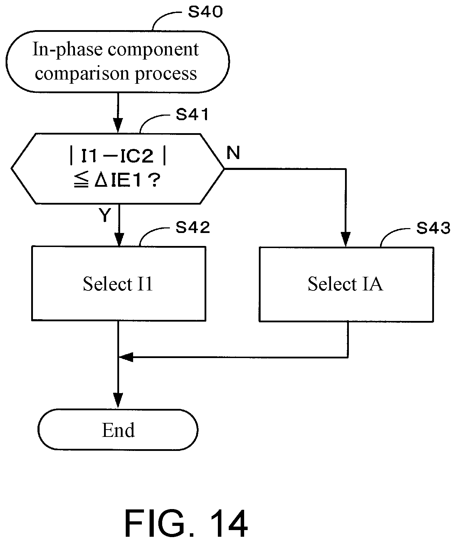

FIG. **14** shows a flowchart of the in-phase component comparison process (S40). The in-phase component comparison process is the same as the quadrature component comparison process described above (see FIG. 13), except that "quadrature" is replaced with "in-phase" and the reference sign "Q" is replaced with the reference sign "I". Thus, repeated descriptions will be omitted.

As shown in FIG. 7, upon ending of the noise determination process (S2), a contact detection process (S3) is executed. In the contact detection process (S3), the contact determination part 33 detects contact of a conductor with the electrostatic sensor 7 based on the quadrature component and the in-phase component selected in the noise determination process.

The contact determination part 33 of this embodiment detects contact of a conductor with the electrostatic sensor 7 based on the quadrature component Q1 and Q2 or the corrected quadrature component QC2 selected in the noise determination process (S2). Further, the contact determination part 33 detects contact of a conductor with the electrostatic sensor 7 based on the in-phase component I1 and I2 or the corrected in-phase component IC2 selected in the noise determination process. Since the process executed by the contact determination part 33 is substantially the same as in Embodiment 1, repeated descriptions will be omitted. Accordingly, the contact detection process (S3) ends.

### (4) Updating process

As shown in FIG. 7, upon ending of the contact detection process (S3), an updating process (S4) is executed.

In the quadrature component comparison process (S30 in FIG. 13), in the case where the first quadrature component Q1 and the corrected second quadrature component QC2 fall within the range of the first quadrature error ΔQE1 (S31 in FIG. 13: Y), the quadrature component updating part 35 updates the first quadrature component Q1 used by the contact determination part 33 as the alternative quadrature component QA stored in the storage part 64.

Further, in the in-phase component comparison process (S40 in FIG. 14), in the case where the first in-phase component I1 and the corrected second in-phase component IC2 fall within the range of the first in-phase error ΔIE1 (S41 in FIG. 14: Y), the in-phase component updating part 36 updates the first in-phase component I1 used by the contact determination part 33 as the alternative in-phase component IA stored in the storage part 64. Accordingly, the updating process (S4) ends.

Actions other than those described above are similar to those in Embodiment 1, so repeated descriptions will be omitted.

Next, effects of this embodiment will be described. In this embodiment, in the case where noise of a frequency in the vicinity of the first frequency is mixed in, contact of a conductor with the first electrode layer 22 can be detected based on the alternative quadrature component QA stored in the storage part 64. Accordingly, the influence of noise on the contact detection device 60 can be reduced.

Further, according to this embodiment, to detect contact of a conductor with the first electrode layer 22 of the electrostatic sensor 7, by using the in-phase component in addition to the quadrature component described above, accuracy of the contact detection device 60 can be improved.

Further, according to this embodiment, in the case where the first quadrature component Q1 and the corrected second quadrature component QC2 fall outside the range of the first quadrature error ΔQE1, and the first in-phase component I1 and the corrected second in-phase component IC2 fall outside the range of the first in-phase error ΔIE1, contact of a conductor with the electrostatic sensor 7 can be detected based on the alternative quadrature component QA stored in the storage part 64 and used in the previous determination, and the alternative in-phase component IA stored in the storage part 64 and used in the previous determination.

Further, in this embodiment, the first frequency is greater than the second frequency. Due to the nature of impedance, by applying an AC voltage with a great frequency, accuracy of the contact detection device 60 can be improved. Thus, in the case where the first frequency greater than the second frequency can be used for detecting a conductor, accuracy of the contact detection device 60 can be improved. According to this embodiment, in the case where noise of a frequency close to the first frequency is not mixed in, contact of a conductor with the first electrode layer 22 can be detected based on the alternative component (alternative quadrature component QA or alternative in-phase component IA) stored in the storage part 64 and used in the previous determination. Thus, accuracy of the contact detection device 60 can be improved as much as possible.

The present disclosure is not limited to the above embodiments and may be applied to various embodiments without departing from the spirit thereof.

In this embodiment, the alternative quadrature component QA and the alternative in-phase component IA are respectively updated by the quadrature component updating part 35 and the in-phase component updating part 36. However, the disclosure is not limited thereto, and the quadrature component updating part 35 and the in-phase component updating part 36 may also be omitted, or the alternative quadrature component QA and the alternative in-phase component IA may also be initial values stored in the storage part 64 that are not updated.

## Claims

1. A contact detection device (10, 60) comprising:
an electrostatic sensor (7) comprising a detection electrode (22, 23) and detecting contact of a conductor;
an AC power supply (11) applying an AC voltage to the detection electrode;
a quadrature demodulator (12) extracting at least a quadrature component in a case where an impedance of the electrostatic sensor is represented by an in-phase component and the quadrature component, using a signal outputted from the detection electrode upon applying the AC voltage to the detection electrode; and
a measuring instrument (30) detecting whether the conductor is in contact with the electrostatic sensor based on the quadrature component extracted by the quadrature demodulator, wherein
the AC power supply switches between a first AC voltage of a first frequency and a second AC voltage of a second frequency different from the first frequency to apply the first AC voltage and the second AC voltage to the detection electrode, and
the measuring instrument comprises:
a storage part (34, 64) storing an alternative quadrature component (QA) corresponding to a state in which the conductor is in contact with the electrostatic sensor;
a quadrature component comparison part (31) comparing between a first quadrature component (Q1) extracted by the quadrature demodulator upon applying the first AC voltage to the detection electrode, and a second quadrature component (Q2) extracted by the quadrature demodulator upon applying the second AC voltage to the detection electrode; and
a contact determination part (33) that detects contact of the conductor with the electrostatic sensor based on the first quadrature component in a case where the first quadrature component and the second quadrature component fall within a range of a predetermined first quadrature error (ΔQE1), and detects contact of the conductor with the electrostatic sensor based on the alternative quadrature component stored in the storage part in a case where the first quadrature component and the second quadrature component fall outside the range of the first quadrature error.

2. The contact detection device according to claim 1, wherein
the AC power supply switches between the first AC voltage and the second AC voltage at a predetermined cycle to apply the first AC voltage and the second AC voltage to the detection electrode.

3. The contact detection device according to claim 1 or 2, wherein
the alternative quadrature component is an initial value stored in advance in the storage part and is a value that is not updated during contact detection performed by the measuring instrument.

4. The contact detection device according to claim 1 or 2, wherein
the measuring instrument comprises:
a quadrature component updating part (35) updating the first quadrature component used by the contact determination part as the alternative quadrature component stored in the storage part in a case where the first quadrature component and the second quadrature component fall within the range of the first quadrature error, and
the contact determination part detects contact of the conductor with the electrostatic sensor based on the alternative quadrature component updated in the storage part and used in a previous determination, in a case where the first quadrature component and the second quadrature component fall outside the range of the first quadrature error.

5. The contact detection device according to claim 1 or 2, wherein
the quadrature demodulator extracts the in-phase component and the quadrature component,
the measuring instrument detects whether the conductor is in contact with the electrostatic sensor based on the in-phase component and the quadrature component extracted by the quadrature demodulator,
the storage part stores an alternative in-phase component (IA) and the alternative quadrature component corresponding to a state in which the conductor is in contact with the electrostatic sensor,
the measuring instrument comprises:
an in-phase component comparison part (32) comparing between a first in-phase component (II) extracted by the quadrature demodulator upon applying the first AC voltage to the detection electrode, and a second in-phase component (I2) extracted by the quadrature demodulator upon applying the second AC voltage to the detection electrode, and
the contact determination part:
detects contact of the conductor with the electrostatic sensor based on the first quadrature component and the first in-phase component, in a case where the first quadrature component and the second quadrature component fall within the range of the first quadrature error and the first in-phase component and the second in-phase component fall within a range of a predetermined first in-phase error (ΔIE1), and
detects contact of the conductor with the electrostatic sensor based on the alternative quadrature component and the alternative in-phase component stored in the storage part, in a case where the first quadrature component and the second quadrature component fall outside the range of the first quadrature error and the first in-phase component and the second in-phase component fall outside the range of the first in-phase error.

6. The contact detection device according to claim 5, wherein
the alternative quadrature component is an initial value stored in advance in the storage part and is a value that is not updated during contact detection performed by the measuring instrument, and
the alternative in-phase component is an initial value stored in advance in the storage part and is a value that is not updated during contact detection performed by the measuring instrument.

7. The contact detection device according to claim 5, wherein
the measuring instrument comprises:
a quadrature component updating part (35) updating the first quadrature component used by the contact determination part as the alternative quadrature component stored in the storage part in a case where the first quadrature component and the second quadrature component fall within the range of the first quadrature error; and
an in-phase component updating part (36) updating the first in-phase component used by the contact determination part as the alternative in-phase component stored in the storage part in a case where the first in-phase component and the second in-phase component fall within the range of the first in-phase error, and
the contact determination part detects contact of the conductor with the electrostatic sensor based on the alternative quadrature component and the alternative in-phase component updated in the storage part and used in a previous determination, in a case where the first quadrature component and the second quadrature component fall outside the range of the first quadrature error and the first in-phase component and the second in-phase component fall outside the range of the first in-phase error.

8. The contact detection device according to claim 1 or 2, wherein
the first frequency is greater than the second frequency.

9. The contact detection device according to claim 1, wherein
the AC power supply switches between the first AC voltage, the second AC voltage, and a third AC voltage of a third frequency different from the first frequency and the second frequency to apply the first AC voltage, the second AC voltage, and the third AC voltage to the detection electrode,
the quadrature component comparison part compares between the first quadrature component, the second quadrature component, and a third quadrature component (Q3) extracted by the quadrature demodulator upon applying the third AC voltage to the detection electrode, and
the contact determination part detects contact of the conductor with the electrostatic sensor based on the first quadrature component in a case where the first quadrature component and the second quadrature component fall within the range of the first quadrature error, compares between the first quadrature component and the third quadrature component in a case where the first quadrature component and the second quadrature component fall outside the range of the first quadrature error, detects contact of the conductor with the electrostatic sensor based on the first quadrature component in a case where the first quadrature component and the third quadrature component fall within a range of a predetermined second quadrature error (ΔQE2), compares between the second quadrature component and the third quadrature component in a case where the first quadrature component and the third quadrature component fall outside the range of the second quadrature error, detects contact of the conductor with the electrostatic sensor based on the second quadrature component in a case where the second quadrature component and the third quadrature component fall within a range of a predetermined third quadrature error (ΔQE3), and detects contact of the conductor with the electrostatic sensor based on the alternative quadrature component stored in the storage part in a case where the second quadrature component and the third quadrature component fall outside the range of the third quadrature error.

10. The contact detection device according to claim 9, wherein
the AC power supply switches between the first AC voltage, the second AC voltage, and the third AC voltage at a predetermined cycle to apply the first AC voltage, the second AC voltage, and the third AC voltage to the detection electrode.

11. The contact detection device according to claim 9 or 10, wherein
the alternative quadrature component is an initial value stored in advance in the storage part and is a value that is not updated during contact detection performed by the measuring instrument.

12. The contact detection device according to claim 9 or 10, wherein
the measuring instrument comprises:
a quadrature component updating part (35) that updates the first quadrature component used by the contact determination part as the alternative quadrature component stored in the storage part in a case where the first quadrature component and the second quadrature component fall within the range of the first quadrature error, updates the first quadrature component used by the contact determination part as the alternative quadrature component stored in the storage part in a case where the first quadrature component and the third quadrature component fall within the range of the second quadrature error, and updates the second quadrature component used by the contact determination part as the alternative quadrature component stored in the storage part in a case where the second quadrature component and the third quadrature component fall within the range of the third quadrature error, and
the contact determination part detects contact of the conductor with the electrostatic sensor based on the alternative quadrature component updated in the storage part and used in a previous determination, in a case where the first quadrature component and the second quadrature component fall outside the range of the first quadrature error, the first quadrature component and the third quadrature component fall outside the range of the second quadrature error, and the second quadrature component and the third quadrature component fall outside the range of the third quadrature error.

13. The contact detection device according to claim 9 or 10, wherein
the quadrature demodulator extracts the in-phase component and the quadrature component,
the measuring instrument detects whether the conductor is in contact with the electrostatic sensor based on the in-phase component and the quadrature component extracted by the quadrature demodulator,
the storage part stores an alternative in-phase component and the alternative quadrature component corresponding to a state in which the conductor is in contact with the electrostatic sensor,
the measuring instrument comprises:
an in-phase component comparison part (32) comparing between a first in-phase component extracted by the quadrature demodulator upon applying the first AC voltage to the detection electrode, a second in-phase component extracted by the quadrature demodulator upon applying the second AC voltage to the detection electrode, and a third in-phase component (I3) extracted by the quadrature demodulator upon applying the third AC voltage to the detection electrode, and
the contact determination part:
detects contact of the conductor with the electrostatic sensor based on the first quadrature component and the first in-phase component in a case where the first quadrature component and the second quadrature component fall within the range of the first quadrature error and the first in-phase component and the second in-phase component fall within a range of a predetermined first in-phase error (ΔIE1),
detects contact of the conductor with the electrostatic sensor based on the first quadrature component and the first in-phase component in a case where the first quadrature component and the third quadrature component fall within the range of the second quadrature error and the first in-phase component and the third in-phase component fall within a range of a predetermined second in-phase error (ΔIE2),
detects contact of the conductor with the electrostatic sensor based on the second quadrature component and the second in-phase component in a case where the second quadrature component and the third quadrature component fall within the range of the third quadrature error and the second in-phase component and the third in-phase component fall within a range of a predetermined third in-phase error (ΔIE3), and
detects contact of the conductor with the electrostatic sensor based on the alternative quadrature component and the alternative in-phase component stored in the storage part, in a case where the first quadrature component and the second quadrature component fall outside the range of the first quadrature error, the first in-phase component and the second in-phase component fall outside the range of the first in-phase error, the first quadrature component and the third quadrature component fall outside the range of the second quadrature error, the first in-phase component and the third in-phase component fall outside the range of the second in-phase error, the second quadrature component and the third quadrature component fall outside the range of the third quadrature error, and the second in-phase component and the third in-phase component fall outside the range of the third in-phase error.

14. The contact detection device according to claim 13, wherein
the alternative quadrature component is an initial value stored in advance in the storage part and is a value that is not updated during contact detection performed by the measuring instrument, and
the alternative in-phase component is an initial value stored in advance in the storage part and is a value that is not updated during contact detection performed by the measuring instrument.

15. The contact detection device according to claim 13, wherein
the measuring instrument comprises:
an in-phase component updating part (36) that updates the first in-phase component used by the contact determination part as the alternative in-phase component stored in the storage part in a case where the first in-phase component and the second in-phase component fall within the range of the first in-phase error, updates the first in-phase component used by the contact determination part as the alternative in-phase component stored in the storage part in a case where the first in-phase component and the third in-phase component fall within the range of the second in-phase error, and updates the second in-phase component used by the contact determination part as the alternative in-phase component stored in the storage part in a case where the second in-phase component and the third in-phase component fall within the range of the third in-phase error, and
the contact determination part detects contact of the conductor with the electrostatic sensor based on the alternative in-phase component updated in the storage part and used in a previous determination, in a case where the first in-phase component and the second in-phase component fall outside the range of the first in-phase error, the first in-phase component and the third in-phase component fall outside the range of the second in-phase error, and the second in-phase component and the third in-phase component fall outside the range of the third in-phase error.

16. The contact detection device according to claim 9 or 10, wherein
the first frequency is greater than the second frequency, and the second frequency is greater than the third frequency.

17. The contact detection device according to claim 16, wherein
the first frequency is 100 to 150 kHz.

18. The contact detection device according to claim 17, wherein
the second frequency is 50 to 100 kHz.

19. The contact detection device according to claim 18, wherein
the third frequency is 5 to 50 kHz.
